# FASCICULE DE BREVET EUROPEEN

(11) **EP 2 943 329 B1**
(45) Date de publication et mention de la délivrance du brevet: **16.05.2018**
(21) Numéro de dépôt: 14700275.2
(22) Date de dépôt: 09.01.2014
(51) Int. Cl.: B29C 67/00

(54) **FABRICATION D'UN OBJET EN VOLUME PAR LITHOGRAPHIE, A RESOLUTION SPATIALE AMELIOREE**
HERSTELLUNG EINES VOLUMENOBJEKTS MIT VERBESSERTER RÄUMLICHER AUFLÖSUNG MITTELS LITHOGRAFIE
PRODUCTION OF A VOLUME OBJECT BY LITHOGRAPHY, HAVING IMPROVED SPATIAL RESOLUTION

(30) Priorité: 09.01.2013 FR 1350177
(43) Date de publication de la demande: 18.11.2015
(73) Titulaire: PRODWAYS, 78130 Les Mureaux (FR)
(72) Inventeur: ALLANIC, André-Luc, 78270 Mousseaux-sur-Seine (FR)
(74) Mandataire: Santarelli
(86) Numéro de dépôt international: PCT/EP2014/050326
(87) Numéro de publication internationale: WO 2014/108473

(56) Documents cités:
- WO-A1-95/15841

## Description

### Domaine technique

La présente invention concerne un dispositif de fabrication d'un objet en volume par lithographie et un procédé de mis en oeuvre par un tel dispositif. L'invention permet notamment de réaliser plusieurs lithographies successives de couches superposées afin de fabriquer un produit en trois dimensions. Le domaine de l'invention est donc plus particulièrement mais de manière non limitative celui du prototypage rapide et de la stéréolithographie.

### Etat de la technique antérieure

On connaît des procédés de fabrication de produits (typiquement des prototypes) en trois dimensions par empilement de couches, comme par exemple par stéréolithographie ou par dépôt de filament (ou FDM pour « fused deposition Modeling »).

Le principe de la stéréolithographie est le suivant :
1) on projette au moins une image de projection sur une couche photo réactive, ladite couche photo réactive se solidifiant sur l'aire illuminée par l'image de projection (l'image de projection forme généralement un motif, obtenu par l'interaction entre une source de lumière et un masque), puis
2) on recouvre la couche partiellement solidifiée par une nouvelle couche photo réactive, puis
3) on projette une nouvelle fois au moins une image de projection sur cette nouvelle couche photo réactive,
les étapes 2) et 3) étant réitérées autant de fois que nécessaire pour réaliser un produit en trois dimensions. Généralement, l'image de projection varie pour chaque couche. Par exemple, pour réaliser une boule, on solidifie un disque dont le diamètre croît d'une première couche à une couche médiane, puis décroît de la couche médiane à une dernière couche.

Cette technique permet de réaliser des produits en trois dimensions directement dans une résine photopolymérisable sans usinage. L'image solidifiée ou à solidifier d'une couche est appelée image de consigne. L'image de projection peut être bien plus petite l'image de consigne : dans ce cas-là, il faut déplacer l'image de projection dans différents endroits d'une couche en modifiant cette image de projection.

Un enjeu de la stéréolithographie tel que représenté par exemple par un dispositif selon le document EP 1,344,633B1 ou US 5,247,180 est d'en améliorer la résolution spatiale. Cette résolution est limitée aujourd'hui, notamment par la longueur d'onde et la qualité optique de l'image de projection générée par un masque et différentes lentilles.

Par ailleurs, il est désirable de manière générale de simplifier la structure et le fonctionnement des dispositifs de lithographie.

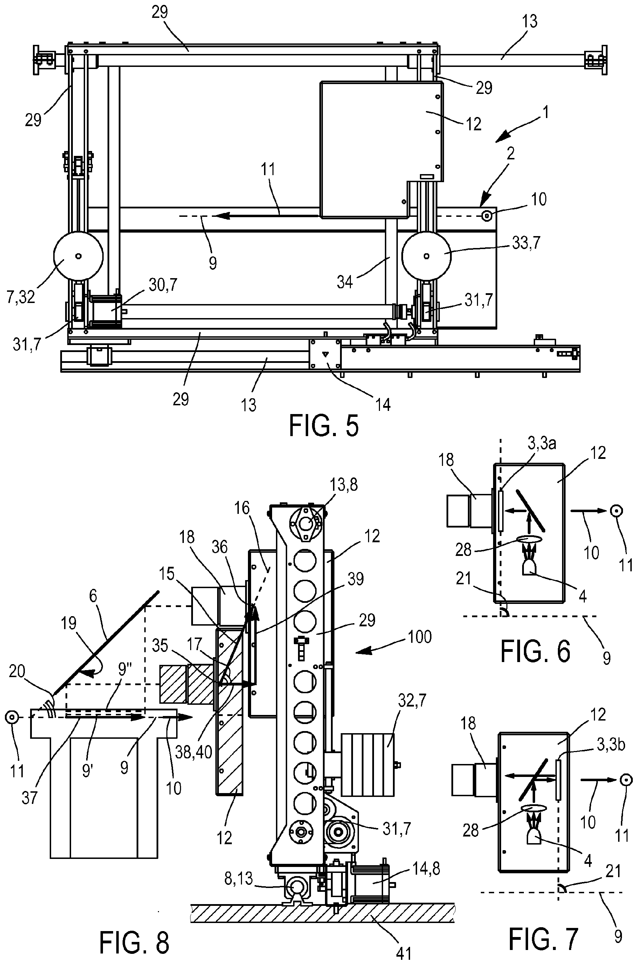

Le document WO 95/15841 présente un dispositif de lithographie, comprenant en particulier un masque « actif », ledit masque pouvant prendre la forme d'une barrette de cristaux liquides qui illumine toute la largeur d'une cuve de matériau photosensible. L'image formée sur cette largeur entière peut être déplacée selon une direction unique (direction F de la figure 5).

Ce document mentionne également la possibilité de projeter l'image du masque sur une vitre immergée dans une cuve remplie de résine liquide, la vitre remontant au fur et à mesure de la formation de l'objet. Selon cette possibilité, le masque et les autres éléments optiques du dispositif sont solidaires et accompagnent le mouvement vertical de la vitre.

Le but de la présente invention est de proposer un procédé ou dispositif de lithographie d'objets 3D à résolution améliorée.

### Exposé de l'invention

Cet objectif est atteint avec un dispositif selon la revendication 10 de fabrication d'un objet en volume par lithographie, comprenant :
- un réceptacle agencé pour recevoir, dans un volume de travail, une couche de matière,
- un masque et une source de rayonnement agencés pour créer ensemble une image de projection en sortie du masque,
- des moyens pour projeter l'image de projection sur un plan à illuminer dans le volume de travail, ces moyens de projection comprenant des moyens pour déplacer l'image de projection dans le plan à illuminer le long d'une première direction de déplacement et des moyens pour déplacer l'image de projection dans le plan à illuminer le long d'une deuxième direction de déplacement différente de la première direction et non superposée à la première direction,
dans lequel les moyens pour déplacer l'image de projection le long de la première direction de déplacement comprennent :
- des moyens pour déplacer le masque selon un mouvement ayant une composante le long d'un axe oblique formant un angle avec le plan à illuminer,
- et de préférence des moyens (typiquement un miroir agencé pour réfléchir vers le plan à illuminer l'image de projection issue du masque) pour transformer le mouvement du masque ayant la composante le long de l'axe oblique formant l'angle avec le plan à illuminer en un déplacement de l'image de projection sur le plan à illuminer le long de la première direction de déplacement contenue dans le plan à illuminer.

Les moyens pour déplacer le masque selon le mouvement ayant la composante le long de l'axe oblique sont de préférence agencés pour déplacer le masque le long de l'axe oblique.

L'axe oblique forme de préférence un angle droit avec le plan à illuminer.

Le dispositif selon l'invention peut comprendre en outre des moyens pour modifier dynamiquement l'image de projection de manière synchronisée avec le déplacement de l'image de projection le long de la première direction, comprenant des moyens pour modifier dynamiquement le masque de manière synchronisée avec le mouvement du masque ayant la composante le long de l'axe oblique.

Le miroir peut avoir une surface réfléchissante agencée pour réfléchir l'image de projection et inclinée à 45 ° plus ou moins 10 ° par rapport au plan à illuminer.

Les moyens pour projeter l'image de projection sont de préférence agencés pour projeter cette image de sorte qu'entre le masque et le miroir l'image de projection se propage parallèlement au plan à illuminer.

Le masque peut ne pas être parallèle, et est plutôt de préférence perpendiculaire, au plan à illuminer.

Les moyens pour déplacer l'image de projection le long de la première direction de déplacement peuvent être agencés pour déplacer l'image de projection dans le plan à illuminer successivement le long de plusieurs lignes parallèles, les moyens pour déplacer l'image de projection le long de la deuxième direction de déplacement peuvent être agencés pour décaler l'image de projection à la fin de chaque ligne finie vers une ligne suivante parallèle à la ligne finie, de sorte qu'une position de l'image de projection sur le plan à illuminer le long de la ligne finie soit bordée ou partiellement superposée avec une position de l'image de projection sur le plan à illuminer le long la ligne suivante.

Les moyens pour projeter l'image de projection sur le plan à illuminer sont de préférence agencés pour pouvoir projeter l'image de projection sur différents plans à illuminer possibles, parallèles et contenus dans le volume de travail.

Suivant encore un autre aspect de l'invention, il est proposé un procédé selon la revendication 1 de fabrication d'un objet en volume par lithographie, comprenant :
- fournir dans un volume de travail une couche de matière photosensible agencée pour se durcir sous l'influence d'un rayonnement,
- une création, par un masque et une source de rayonnement, d'une image de projection en sortie du masque,
- une projection de l'image de projection sur un plan à illuminer de la couche de matière,
- un déplacement de l'image de projection dans le plan à illuminer le long d'une première direction de déplacement et un déplacement de l'image de projection dans le plan à illuminer le long d'une deuxième direction de déplacement différente de la première direction et non superposée à la première direction, ces deux directions de déplacement étant contenues dans le plan à illuminer,
dans lequel pour déplacer l'image de projection le long de la première direction de déplacement :
- on déplace le masque selon un mouvement ayant une composante le long d'un axe oblique formant un angle avec le plan à illuminer, et
- et de préférence on transforme ce mouvement du masque ayant la composante le long de l'axe oblique formant l'angle avec le plan à illuminer en le déplacement de l'image de projection sur le plan à illuminer le long de la première direction de déplacement contenue dans le plan à illuminer, de typiquement au moyen d'un miroir qui réfléchit vers le plan à illuminer l'image de projection issue du masque.

Pour déplacer le masque selon le mouvement ayant la composante le long de l'axe oblique, on déplace de préférence le masque le long de l'axe oblique.

L'axe oblique forme de préférence un angle droit avec le plan à illuminer.

Le procédé selon l'invention peut comprendre au cours du déplacement le long de la première direction, une modification dynamique de l'image de projection synchronisée avec le déplacement de l'image de projection le long de la première direction, cette modification de l'image étant obtenue par une modification dynamique du masque synchronisée avec le déplacement du masque selon son mouvement ayant la composante le long de l'axe oblique.

Le miroir peut avoir une surface réfléchissante agencée pour réfléchir l'image de projection et inclinée à 45 ° plus ou moins 10 ° par rapport au plan à illuminer.

Entre le masque et le miroir l'image de projection se propage de préférence parallèlement au plan à illuminer.

Le masque n'est de préférence pas parallèle, et est de préférence perpendiculaire, au plan à illuminer.

On peut déplacer l'image de projection dans le plan à illuminer le long de la première direction de déplacement successivement le long de plusieurs lignes parallèles, et on peut déplacer l'image de projection le long de la deuxième direction de déplacement pour décaler l'image de projection à la fin de chaque ligne finie vers une ligne suivante parallèle à la ligne finie, de sorte qu'une position de l'image de projection sur le plan à illuminer le long de la ligne finie soit bordée ou partiellement superposée avec une position de l'image de projection sur le plan à illuminer le long la ligne suivante.

On réitère de préférence les étapes du procédé selon l'invention sur plusieurs couches de matière photosensible superposées.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 est une vue en perspective d'un premier mode de réalisation de dispositif selon l'invention, avec sa tête en position « haute »,
- la figure 2 est une vue en perspective d'une partie du dispositif selon l'invention de la figure 1, avec sa tête en position « basse »,
- la figure 3 est une vue de profil du dispositif selon l'invention de la figure 1 selon l'axe de vue A de la figure 1, avec sa tête en position « basse »,
- la figure 4 est une vue de profil du dispositif selon l'invention de la figure 1 selon l'axe de vue A de la figure 1, avec sa tête en position « haute »,
- la figure 5 est une vue de dos du dispositif selon l'invention de la figure 1 selon l'axe de vue B de la figure 1,
- la figure 6 est une vue schématique de profil de l'intérieur d'une première variante de la tête 12 du dispositif selon l'invention de la figure 1,
- la figure 7 est une vue schématique de profil de l'intérieur d'une deuxième variante de la tête 12 du dispositif selon l'invention de la figure 1, et
- la figure 8 est une vue de profil d'un deuxième mode de réalisation de dispositif selon l'invention, avec sa tête 12 en position « basse » et en position « haute » à deux instants différents pour illustrer un mouvement de cette tête.

Ces modes de réalisation n'étant nullement limitatifs, on pourra notamment considérer des variantes de l'invention ne comprenant qu'une sélection de caractéristiques décrites par la suite isolées des autres caractéristiques décrites (même si cette sélection est isolée au sein d'une phrase comprenant ces autres caractéristiques), si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si cette partie uniquement est suffisante pour conférer un avantage technique ou à différencier l'invention par rapport à l'état de la technique antérieure.

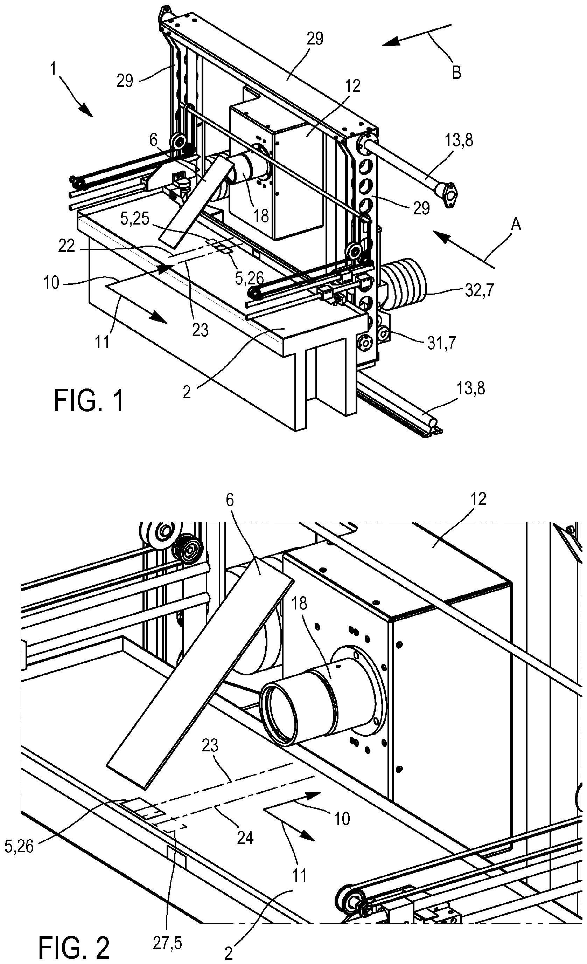

On va tout d'abord décrire, en référence aux figures 1 à 7, un premier mode de réalisation de dispositif 1 selon l'invention.

Le dispositif 1 est un dispositif de stéréolithographie.

Le dispositif 1 est prévu pour fabriquer un objet en volume (tel un prototype) par lithographie de plusieurs couches superposées.

Le dispositif 1 comprend un réceptacle 2 agencé pour recevoir, dans un volume de travail, une couche de matière photosensible ou photo-réactive ou photo-polymérisable agencée pour se durcir sous l'influence d'un rayonnement de durcissement.

Le rayonnement de durcissement est un rayonnement électromagnétique, typiquement de lumière visible (longueur d'onde comprise entre 380 et 780 nanomètres), ou bien plutôt de préférence de lumière ultraviolette (longueur d'onde typique comprise entre 355 et 385 nanomètres).

La matière photosensible n'est pas nécessairement un liquide. La matière photosensible est un liquide, une pâte, un gel ou toute autre matière molle agencée pour se durcir sous l'influence du rayonnement de durcissement. Par exemple, on peut utiliser comme matière photosensible des résines de référence Innovation Meditech FotoMed.LED A/Pattern/Flex 70. Des pâtes à charge métallique ou céramique sont aussi envisageables, basées sur par exemple les matériaux développés dans les années 2000 pour le procédé OptoForm.

Le réceptacle 2 peut être un réservoir (par exemple si la matière photosensible est un liquide) ou un plateau ou une plaque (par exemple si la matière photosensible est un gel ou une pâte) ou même une grille (par exemple si la matière photosensible est une pâte ne s'écoulant quasiment pas).

Le dispositif 1 comprend en outre un masque 3 et une source 4 agencée pour émettre le rayonnement de durcissement.

La source 4 est généralement couplée à une lentille 28 ou à un jeu de lentilles 28.

La source 4 consiste typiquement en une diode électroluminescente (DEL) de puissance de référence Nichia NLBU21P02

Le masque 3 peut être par exemple :
- soit (Figure 6) un écran à cristal liquide 3a constitué de pixels de cristal liquide, chaque pixel étant allumé (transparent pour le rayonnement de durcissement) ou éteint (opaque pour le rayonnement de durcissement) selon l'état du cristal liquide de ce pixel,
- soit (Figure 7) une puce (DLP pour « Digital Light Processor », par exemple de type XGA ou 1080p) 3b constituée d'un quadrillage de miroirs mobiles, chaque miroir mobile correspondant à un pixel du masque 3 qui est allumé ou éteint selon la position de ce miroir mobile.

Le masque 3 comprend donc des pixels. Le masque 3 et la source 4 sont agencés pour créer ensemble une image de projection 5 en sortie du masque 3 :
- Soit par réflexion, par le masque 3 (exemple de la puce DLP), du rayonnement de durcissement provenant de la source 4,
- Soit par transmission, à travers le masque 3 (exemple de l'écran à cristal liquide), du rayonnement de durcissement provenant de la source 4,
l'état allumé ou éteint de chacun des pixels du masque 3 correspondant à un pixel de l'image de projection 5 respectivement illuminé ou non par le rayonnement de durcissement.

Le masque 3 et la source 4 sont regroupés à l'intérieur d'une tête 12.

La tête 12 est montée à l'intérieur d'un cadre 29 (métallique) typiquement de forme rectangulaire.

Le dispositif 1 comprend en outre des moyens 6, 7, 8 pour projeter l'image de projection 5 de manière focalisée sur un plan à illuminer 9 dans le volume de travail.

Ces moyens de projection 6, 7, 8 comprennent des moyens 6, 7 pour déplacer l'image de projection 5 dans le plan à illuminer 9 le long d'une première direction 10 de déplacement. Ces moyens de projection 6, 7, 8 comprennent des moyens 8 pour déplacer l'image de projection dans le plan à illuminer 9 le long d'une deuxième direction 11 de déplacement.

La deuxième direction 11 de déplacement est différente de la première direction 10 et n'est pas superposée (i.e pas parallèle) à la première direction 10. De préférence, la deuxième direction 11 de déplacement est perpendiculaire à la première direction 10. Ces deux directions 10, 11 de déplacement sont contenues dans le plan 9 à illuminer.

L'image de projection 5, issue de la tête 12, peut ainsi être déplacée selon deux directions différentes du plan à illuminer 9. De la sorte, en déplaçant cette image 5 selon les deux directions, on peut couvrir une zone désirée du plan 9.

Les moyens 8 pour déplacer l'image de projection le long de la deuxième direction 11 de déplacement comprennent typiquement une ou plusieurs barre(s) 13 (métalliques) s'étendant le long de cette deuxième direction 11, et un moteur 14 agencé pour déplacer le masque 3 et la source 4 (plus exactement la tête 12, plus exactement le cadre 29) le long de(s) barre(s) 13 et donc le long de cette deuxième direction 11. Le moteur 14 fait coulisser le cadre 29 le long de l'au moins une barre 13.

Les moyens 6, 7 pour déplacer l'image de projection 5 le long de la première direction 10 de déplacement comprennent :
- des moyens 7 pour déplacer le masque 3 selon un mouvement ayant une composante 15 le long d'un axe oblique 16 formant un angle 17 (non nul) avec le plan à illuminer 9.
- un miroir 6 agencé pour :
   ∘ réfléchir vers le plan à illuminer 9 l'image de projection 5 issue du masque 3
   ∘ et transformer ainsi « le mouvement du masque 3 ayant la composante 15 le long de l'axe oblique 16 formant l'angle 17 avec le plan à illuminer 9 » en « un déplacement de l'image de projection 5 sur le plan à illuminer 9 le long de la première direction de déplacement 10 contenue dans le plan à illuminer 9».

En d'autres termes, la combinaison :
- du fait que l'image 5 issue du masque 3 ait un mouvement oblique par rapport au plan à illuminer 9, avec une composante 15,
- et du fait que cette image 5 issue du masque 3 est projetée vers le miroir de manière à être réfléchie en une image de projection 5 vers le plan à illuminer 9,
aboutit à un déplacement de cette image projetée 5, sur le plan à illuminer 9.

Et ce déplacement est obtenu selon la première direction 10.

Cette première direction 10, contenue dans le plan à illuminer 9, est typiquement la direction d'émission de la lumière par la tête 12. En variante, la direction 10 peut être une direction du plan 9 qui comprenne une composante selon la direction d'émission de la lumière par la tête 12.

De préférence, le déplacement du masque 3 comprend un déplacement du masque 3 par rapport au miroir 6, et les moyens 7 pour déplacer le masque 3 sont agencés pour déplacer ledit masque 3 par rapport au miroir 6.

On précise que dans ce texte le déplacement du masque 3 est assimilé au déplacement de la tête 12, dont le masque est solidaire.

Après sa sortie du masque 3 et avant d'atteindre le plan à illuminer 9, l'image de projection 5 est mise en forme (dimensionnement, focalisation, etc...). En particulier, en sortie du masque 3 et avant le miroir 6, l'image de projection 5 traverse plusieurs lentilles au sein d'un objectif 18 (solidaire de la tête 12) qui met en forme (dimensionnement, focalisation, etc...) l'image de projection 5.

Les moyens 7 pour déplacer le masque 3 selon le mouvement ayant la composante 15 le long de l'axe oblique 16 sont agencés pour déplacer le masque 3 le long de l'axe oblique 16, i.e. sans autre composante de mouvement que la composante 15.

Les moyens 7 pour déplacer le masque 3 selon le mouvement ayant la composante 15 le long de l'axe oblique 16 comprennent par exemple un moteur 30, un système de transmission 31 (comprenant typiquement des courroies), au moins un (de préférence deux) contrepoids 32, 33, est une barre 34 (typiquement métallique). La barre 34 est solidaire du cadre 29. La barre 34 s'étend longitudinalement de manière parallèle à l'axe oblique 16 ou de préférence perpendiculairement au plan à illuminer. La tête 12 est montée sur la barre 34 et peut se déplacer le long de cette barre 34. Le moteur 30 est agencé pour déplacer la tête 12 le long de cette barre 34. Le système de transmission 31 est agencé, lors du mouvement du masque 3 ou de la tête 12 selon la direction le long de l'axe 16 (vers le haut ou vers le bas), déplacer chaque contrepoids 32, 33 dans une direction opposée (respectivement vers le bas ou vers le haut).

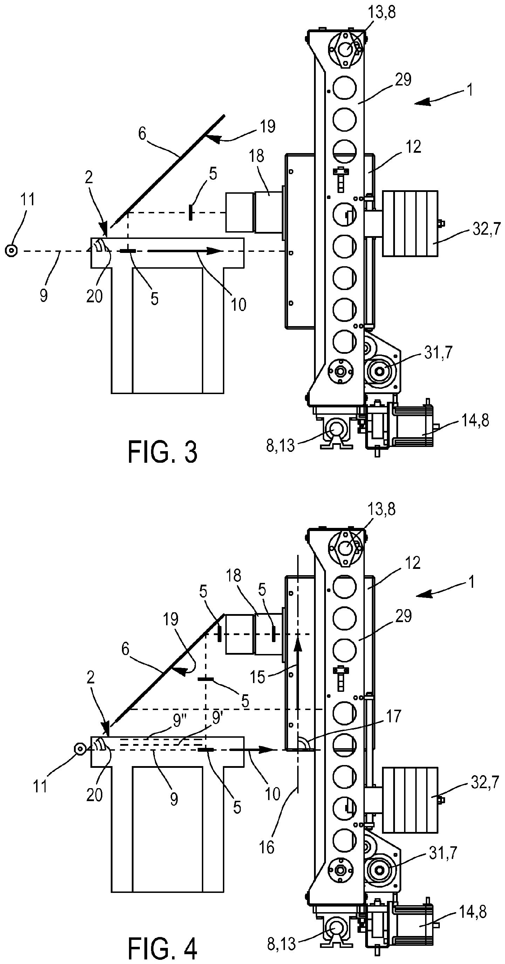

Tel qu'illustré sur la figure 4, l'axe oblique 16 forme un angle droit 17 avec le plan 9 à illuminer, c'est-à-dire qu'il est perpendiculaire avec le plan à illuminer 9.

Ainsi, selon l'invention, pour déplacer l'image de projection 5 dans le plan à illuminer 9 qui est horizontal, on déplace verticalement le masque 3 et donc la tête 12 qui est relativement lourde, c'est-à-dire que l'on déplace le masque 3 et donc la tête 12 le long de la direction de leur propre poids. Cette solution est beaucoup plus stable mécaniquement et permet une bien meilleure résolution spatiale de lithographie. En effet, selon l'art antérieur, lorsque l'on déplace une tête et son masque horizontalement le long d'une barre horizontale, cette barre peut fléchir sous le poids de la tête, et peut entrainer des problèmes de pointé de la tête et donc de l'image de projection, des problèmes de répétabilité de l'orientation de la tête et donc de l'image de projection, et donc des problèmes de résolution spatiale de la lithographie de chaque couche.

Le dispositif 1 comprend en outre des moyens pour modifier l'image de projection 5 dans le plan 9 de manière synchronisée avec le déplacement de l'image de projection 5 le long de la première direction 10 (sur le principe du document EP1,344,633) comprenant toutefois dans le cas spécifique de l'invention des moyens pour modifier le masque 3 de manière synchronisée avec le mouvement du masque 3 ayant la composante 15 le long de l'axe oblique 16. Ces moyens de modification comprennent typiquement des moyens de calcul ou de commande (comprenant un processeur, et/ou un circuit analogique et/ou numérique, et/ou une unité centrale d'un ordinateur, et /ou des moyens logiciels) agencés pour calculer l'image de projection 5 (i.e. quels sont les pixels de l'image de projection 5 illuminés par le rayonnement de durcissement et à quelle intensité qui peut varier d'un pixel à un autre) en fonction d'une image de consigne et de la position actuelle de l'image de projection 5 dans le plan à illuminer 9 (i.e. de la position de la tête 12 ou du masque 3 le long de l'axe 16).

Les moyens de calcul et de commande sont en outre agencés pour commander tous les moteurs du dispositif 1.

Le miroir 6 a une surface réfléchissante 19 agencée pour réfléchir l'image de projection 5 et inclinée à un angle 20 de 45 ° plus ou moins 10 ° (de préférence plus ou moins 1 °) par rapport au plan à illuminer 9.

De préférence, le miroir 6 est fixe dans la première direction par rapport au plan à illuminer.

Les moyens 6, 7, 8 pour projeter l'image de projection 5 sont agencés pour projeter cette image de sorte qu'entre le masque 3 et le miroir 6 l'image de projection 5 se propage parallèlement au plan 9 à illuminer.

Les moyens 6, 7, 8 pour projeter l'image de projection 5 sont agencés pour projeter cette image de sorte qu'entre le miroir 6 et le plan à illuminer 9 l'image de projection se propage perpendiculairement au plan 9 à illuminer.

Le masque 3 est plan. Le plan du masque 3 (plan de la puce DLP ou de l'écran à cristal liquide) n'est pas parallèle au plan 9 à illuminer, et forme un angle 21 de préférence perpendiculaire au plan 9 à illuminer.

Les moyens 6, 7 pour déplacer l'image de projection 5 le long de la première direction 10 de déplacement sont agencés pour déplacer dans le plan 9 l'image de projection 5 successivement le long de plusieurs lignes parallèles 22 à 24 (seules trois lignes sont représentées sur les figures pour ne pas les surcharger).

Les moyens 8 pour déplacer l'image de projection 5 le long de la deuxième direction 11 de déplacement sont agencés pour décaler dans le plan 9 l'image de projection à la fin de chaque ligne finie 22 ou 23 vers une ligne suivante respectivement 23 ou 24 parallèle à la ligne finie, de sorte :
- qu'une position 25 de l'image de projection 5 sur le plan à illuminer 9 le long de la ligne finie 22 soit bordée avec une position 26 de l'image de projection 5 sur le plan à illuminer 9 le long la ligne suivante 23 (c'est-à-dire qu'un bord de l'image de projection 5 dans sa position 25 le long de la ligne finie 22 touche un bord de l'image de projection 5 dans sa position 26 le long de la ligne suivante 23, mais que la position 25 de l'image de projection 5 sur le plan à illuminer 9 le long de la ligne finie 22 ne soit pas superposée avec la position 26 de l'image de projection 5 sur le plan à illuminer 9 le long la ligne suivante 23) ou
- qu'une position 26 de l'image de projection 5 sur le plan 9 à illuminer le long d'une ligne finie 23 soit partiellement superposée avec une position 27 de l'image de projection 5 sur le plan 9 à illuminer le long la ligne suivante 24.

Pour fabriquer des objets en trois dimensions par superposition de plusieurs couches, les moyens 6, 7, 8 pour projeter l'image de projection 5 focalisée sur un plan à illuminer 9 sont agencés pour pouvoir projeter l'image de projection 5 de manière focalisée sur différents plans 9, 9', 9" à illuminer possibles, parallèles et contenus dans le volume de travail, typiquement par réglage de l'objectif 18.

Un procédé de fabrication selon l'invention d'un objet ou produit en volume par stéréolithographie, mis en oeuvre dans le dispositif 1, comprend alors les étapes suivantes :
a) fournir dans le volume de travail la couche de matière photosensible agencée pour se durcir sous l'influence du rayonnement de durcissement,
b) une création, par la source 4 de rayonnement émettant le rayonnement de durcissement et le masque 3 réfléchissant ou transmettant le rayonnement de durcissement émis par la source 4, de l'image de projection 5 en sortie du masque 3,
c) une projection de l'image de projection 5 de manière focalisée sur le plan à illuminer 9 de la couche de matière,
d) un déplacement de l'image de projection 5 dans le plan 9 le long de la première direction 10 de déplacement par les moyens 6,7 puis, de préférence de manière non simultanée, un déplacement de l'image de projection 5 dans le plan 9 le long de la deuxième direction 11 de déplacement par les moyens 8,

Pour déplacer l'image de projection 5 le long de la première direction 10 de déplacement :
- on déplace le masque 3 selon le mouvement ayant la composante 15 le long de l'axe oblique 16 formant un angle 17 avec le plan à illuminer ; entre le masque 3 et le miroir 6 l'image de projection 5 se propage parallèlement au plan à illuminer 9, et
   - on transforme ce « mouvement du masque 3 ayant la composante 15 le long de l'axe oblique 16 » en « le déplacement de l'image de projection 5 sur le plan à illuminer 9 le long de la première direction 10 de déplacement » au moyen du miroir 6 qui réfléchit vers le plan à illuminer 9 l'image de projection 5 issue du masque 3. Entre le miroir 6 et le plan à illuminer 9 l'image de projection 5 se propage perpendiculairement au plan à illuminer 9.

Au cours du déplacement le long de la première direction 10, on modifie (par les moyens de calcul et de commande) l'image de projection 5 de manière synchronisée avec le déplacement de l'image de projection 5 dans le plan 9 le long de la première direction 10, cette modification de l'image 5 étant obtenue par une modification du masque 3 synchronisée avec le déplacement du masque 3 selon son mouvement ayant la composante 15 le long de l'axe oblique 16.

On déplace ainsi l'image de projection 5 dans le plan 9 le long de la première direction 10 de déplacement successivement le long des différentes lignes parallèles 22, 23, 24, et on déplace dans le plan 9 l'image de projection 5 le long de la deuxième direction 11 de déplacement pour décaler l'image de projection 5 à la fin de chaque ligne finie 22, 23 vers une ligne suivante respectivement 23, 24 parallèle à la ligne finie.

On réitère ces étapes a) à d) pour plusieurs couches de matière photosensible superposées pour fabriquer un objet en trois dimensions.

On va maintenant décrire, en référence à la figure 8, un deuxième mode de réalisation de dispositif 100 selon l'invention, mais uniquement pour ses différences par rapport au premier mode de réalisation de dispositif 1. En particulier, les caractéristiques, les références numériques communes, et le procédé mis en oeuvre ne seront pas de nouveau intégralement décrites.

Dans le dispositif 100, la barre 34 ne s'étend pas longitudinalement de manière parallèle à l'axe oblique 16 mais s'étend par contre toujours bien perpendiculairement au plan à illuminer 9.

Dans le dispositif 100, l'axe 16 est comme précédemment oblique par rapport au plan à illuminer 9, c'est-à-dire qu'il n'est pas contenu ou parallèle avec le plan à illuminer 9. Par contre, l'axe 16 n'est pas perpendiculaire au plan à illuminer 9.

La figure 8 illustre deux positions du masque 3 ou de la tête 12 :
- une première position 35 du masque 3 ou de la tête 12 (dessin hachuré de la tête 12) au début du mouvement du masque 3 ayant la composante 15 le long de l'axe oblique 16 formant l'angle 17 avec le plan à illuminer 9 pour un déplacement de l'image 5 dans le plan 9 le long de la ligne 23, et
- une deuxième position 36 du masque 3 ou de la tête 12 (dessin non hachuré de la tête 12) à la fin du mouvement du masque 3 ayant la composante 15 le long de l'axe oblique 16 formant l'angle 17 avec le plan à illuminer 9 pour un déplacement de l'image 5 dans le plan 9 le long de cette même ligne 23.

On remarque que les moyens 6, 7 pour déplacer l'image de projection 5 dans le plan à illuminer 9 le long de la première direction 10 de déplacement sont agencés pour que dans un même intervalle de temps, la distance 37 parcourue par l'image de projection 5 dans le plan à illuminer 9 le long de la première direction 10 de déplacement est supérieure à la distance 38 parcourue par le masque 3 (ou la tête 12) le long de la première direction 10 de déplacement.

On remarque que les moyens 7 pour déplacer le masque 3 selon le mouvement ayant la composante 15 le long l'axe oblique 16 sont agencés pour que ce mouvement se décompose en deux composantes perpendiculaires :
- une première composante 39 perpendiculaire au plan à illuminer 9, et
- une deuxième composante 40 parallèle au plan à illuminer, de préférence plus précisément parallèle à la première direction 10 de déplacement.

Pour cela, dans cet exemple de deuxième mode de réalisation, le cadre 29 est en outre agencé pour se déplacer, grâce à un moteur, le long d'au moins une barre 41 s'étendant longitudinalement le long de la première direction de déplacement 10.

En outre, l'avantage d'amélioration de la stabilité, de réduction des vibrations, d'amélioration de la répétabilité du positionnement et d'amélioration de la résolution de lithographie est toujours présent (certes de manière moins performante) comme pour le premier mode de réalisation, car le masque 3 (ou la tête 12) se déplace toujours au moins en partie (composante 39) selon l'axe vertical de son propre poids pour déplacer horizontalement l'image 5 dans le plan 9.

Bien sûr, l'invention n'est pas limitée aux exemples qui viennent d'être décrits et de nombreux aménagements peuvent être apportés à ces exemples sans sortir du cadre de l'invention, tel que définit par les revendications.

Bien entendu, les différentes caractéristiques, formes, variantes et modes de réalisation de l'invention peuvent être associées les unes avec les autres selon diverses combinaisons dans la mesure où elles ne sont pas incompatibles ou exclusives les unes des autres. En particulier toutes les variantes et modes de réalisation décrits précédemment sont combinables entre eux.

## Revendications

1. Procédé de fabrication d'un objet en volume par lithographie, comprenant :
a) fournir dans un volume de travail une couche de matière photosensible agencée pour se durcir sous l'influence d'un rayonnement,
b) une création, par un masque (3) et une source (4) de rayonnement, d'une image de projection (5) en sortie du masque,
c) une projection de l'image de projection sur un plan à illuminer (9) de la couche de matière,
d) un déplacement de l'image de projection (5) dans le plan à illuminer (9) le long d'une première direction (10) de déplacement et un déplacement de l'image de projection dans le plan à illuminer (9) le long d'une deuxième direction (11) de déplacement différente de la première direction et non superposée à la première direction, ces deux directions de déplacement étant contenues dans le plan à illuminer (9),
procédé dans lequel pour déplacer l'image de projection le long de la première direction (10) de déplacement :
- on déplace le masque (3) selon un mouvement ayant une composante (15) le long d'un axe oblique (16) formant un angle (17) avec le plan à illuminer (9), et
- on transforme ce mouvement du masque (3) ayant la composante (15) le long de l'axe oblique (16) formant l'angle (17) avec le plan à illuminer (9) en le déplacement de l'image de projection (5) sur le plan à illuminer (9) le long de la première direction (10) de déplacement contenue dans le plan à illuminer (9) au moyen d'un miroir (6) qui réfléchit vers le plan à illuminer (9) l'image de projection (5) issue du masque (3).

2. Procédé selon la revendication 1, **caractérisé en ce que** pour déplacer le masque (3) selon le mouvement ayant la composante (15) le long de l'axe oblique (16), on déplace le masque (3) le long de l'axe oblique (16).

3. Procédé selon la revendication 1 ou 2, **caractérisé en ce que** l'axe oblique (16) forme un angle droit avec le plan à illuminer (9).

4. Procédé selon l'une quelconque des revendications 1 à 3, **caractérisé en ce qu'**il comprend au cours du déplacement le long de la première direction (10), une modification dynamique de l'image de projection synchronisée avec le déplacement de l'image de projection le long de la première direction, cette modification de l'image étant obtenue par une modification dynamique du masque synchronisée avec le déplacement du masque selon son mouvement ayant la composante le long de l'axe oblique.

5. Procédé selon l'une quelconque des revendications 1 à 4, **caractérisé en ce que** le miroir (6) a une surface réfléchissante (19) agencée pour réfléchir l'image de projection et inclinée à 45 ° plus ou moins 10 ° par rapport au plan à illuminer.

6. Procédé selon l'une quelconque des revendications 1 à 5, **caractérisé en ce qu'**entre le masque (3) et le miroir (6) l'image de projection se propage parallèlement au plan à illuminer (9).

7. Procédé selon l'une quelconque des revendications 1 à 6, **caractérisé en ce que** le masque (3) n'est pas parallèle, et est de préférence perpendiculaire, au plan à illuminer (9).

8. Procédé selon l'une quelconque des revendications 1 à 7, **caractérisé en ce qu'**on déplace l'image de projection (5) dans le plan à illuminer (9) le long de la première direction (10) de déplacement successivement le long de plusieurs lignes parallèles (22, 23, 24), et on déplace l'image de projection le long de la deuxième direction (11) de déplacement pour décaler l'image de projection à la fin de chaque ligne finie vers une ligne suivante parallèle à la ligne finie, de sorte qu'une position de l'image de projection sur le plan à illuminer le long de la ligne finie soit bordée ou partiellement superposée avec une position de l'image de projection sur le plan à illuminer le long la ligne suivante.

9. Procédé selon l'une quelconque des revendications 1 à 8, **caractérisé en ce qu'**on réitère ses étapes sur plusieurs couches de matière photosensible superposées.

10. Dispositif (1 ; 100) de fabrication d'un objet en volume par lithographie, comprenant :
- un réceptacle (2) agencé pour recevoir, dans un volume de travail, une couche de matière,
- un masque (3) et une source (4) de rayonnement agencés pour créer ensemble une image de projection (5) en sortie du masque,
- des moyens (6, 7, 8) pour projeter l'image de projection sur un plan à illuminer (9) dans le volume de travail, ces moyens de projection comprenant des moyens (6, 7) pour déplacer l'image de projection dans le plan à illuminer le long d'une première direction (10) de déplacement et des moyens (8) pour déplacer l'image de projection dans le plan à illuminer le long d'une deuxième direction (11) de déplacement différente de la première direction et non superposée à la première direction,
dispositif dans lequel les moyens (6, 7) pour déplacer l'image de projection le long de la première direction (10) de déplacement comprennent :
- des moyens (7) pour déplacer le masque selon un mouvement ayant une composante (15) le long d'un axe oblique (16) formant un angle (17) avec le plan (9) à illuminer,
- un miroir (6) agencé pour réfléchir vers le plan (9) à illuminer l'image de projection (5) issue du masque (3) et pour transformer le mouvement du masque (3) ayant la composante (15) le long de l'axe oblique (16) formant l'angle (17) avec le plan (9) à illuminer en un déplacement de l'image de projection (5) sur le plan (9) à illuminer le long de la première direction (10) de déplacement contenue dans le plan à illuminer (9).

11. Dispositif selon la revendication 10, **caractérisé en ce que** les moyens (7) pour déplacer le masque (3) selon le mouvement ayant la composante (15) le long de l'axe oblique (16) sont agencés pour déplacer le masque (3) le long de l'axe oblique (16).

12. Dispositif selon la revendication 10 ou 11, **caractérisé en ce que** l'axe oblique (16) forme un angle droit avec le plan à illuminer (9).

13. Dispositif selon l'une quelconque des revendications 10 à 12, **caractérisé en ce qu'**il comprend en outre des moyens pour modifier dynamiquement l'image de projection de manière synchronisée avec le déplacement de l'image de projection (5) le long de la première direction (10), comprenant des moyens pour modifier dynamiquement le masque (3) de manière synchronisée avec le mouvement du masque ayant la composante (15) le long de l'axe oblique (16).

14. Dispositif selon l'une quelconque des revendications 10 à 13, **caractérisé en ce que** le miroir (6) a une surface réfléchissante (19) agencée pour réfléchir l'image de projection et inclinée à 45 ° plus ou moins 10 ° par rapport au plan à illuminer (9).

15. Dispositif selon l'une quelconque des revendications 10 à 14, **caractérisé en ce que** les moyens (6, 7, 8) pour projeter l'image de projection sont agencés pour projeter cette image de sorte qu'entre le masque (3) et le miroir (6) l'image de projection (5) se propage parallèlement au plan à illuminer (9).

16. Dispositif selon l'une quelconque des revendications 10 à 15, **caractérisé en ce que** le masque (3) n'est pas parallèle, et est de préférence perpendiculaire, au plan à illuminer (9).

17. Dispositif selon l'une quelconque des revendications 10 à 16, **caractérisé en ce que** les moyens (6, 7) pour déplacer l'image de projection (5) le long de la première direction (10) de déplacement sont agencés pour déplacer l'image de projection (5) dans le plan à illuminer (9) successivement le long de plusieurs lignes parallèles (22, 23, 24), les moyens (8) pour déplacer l'image de projection le long de la deuxième direction de déplacement étant agencés pour décaler l'image de projection à la fin de chaque ligne finie vers une ligne suivante parallèle à la ligne finie, de sorte qu'une position de l'image de projection sur le plan à illuminer le long de la ligne finie soit bordée ou partiellement superposée avec une position de l'image de projection sur le plan à illuminer le long la ligne suivante.

18. Dispositif selon l'une quelconque des revendications 10 à 17, **caractérisé en ce que** les moyens (6, 7, 8) pour projeter l'image de projection sur le plan à illuminer sont agencés pour pouvoir projeter l'image de projection sur différents plans (9, 9', 9") à illuminer possibles, parallèles et contenus dans le volume de travail.

## Patentansprüche

1. Verfahren zum Herstellen eines Volumenobjekts durch Lithographie, umfassend:
a) Bereitstellen einer Schicht aus lichtempfindlichem Material, die zum Aushärten unter dem Einfluss von Strahlung vorgesehen ist, in einem Arbeitsvolumen,
b) Erzeugen eines Projektionsbildes durch eine Maske (3) und eine Strahlungsquelle (4) am Ausgang der Maske,
c) Projizieren des Projektionsbildes auf eine zu beleuchtende Ebene (9) der Materialschicht,
d) Verlagern des Projektionsbildes (5) in der zu beleuchtenden Ebene (9) entlang einer ersten Verlagerungsrichtung (10) und Verlagern des Projektionsbildes in der zu beleuchtenden Ebene (9) entlang einer zweiten Verlagerungsrichtung (11), die sich von der ersten Richtung unterscheidet und die erste Richtung nicht überlagert, wobei diese beiden Verlagerungsrichtungen in der zu beleuchtenden Ebene (9) enthalten sind,
bei welchem Verfahren
zum Verlagern des Projektionsbildes entlang der ersten Verlagerungsrichtung (10):
- die Maske (3) durch Bewegung mit einer Komponente (15) entlang einer schrägen Achse (16) verlagert wird, die einen Winkel (17) mit der zu beleuchtenden Ebene (9) einschließt, und
- diese Bewegung der Maske (3) mit der Komponente (15) entlang der schrägen Achse (16), die den Winkel (17) mit der zu beleuchtenden Ebene (9) einschließt, in die Verlagerung des Projektionsbildes (5) auf der zu beleuchtenden Ebene (9) entlang der ersten Verlagerungsrichtung (10), die in der zu beleuchtenden Ebene (9) enthalten ist, mittels eines Spiegels (6) umgewandelt wird, der das von der Maske (3) stammende Projektionsbild (5) zur zu beleuchtenden Ebene (9) reflektiert.

2. Verfahren nach Anspruch 1, **dadurch gekennzeichnet, dass** zum Verlagern der Maske (3) durch Bewegung mit der Komponente (15) entlang der schrägen Achse (16) die Maske (3) entlang der schrägen Achse (16) verlagert wird.

3. Verfahren nach Anspruch 1 oder 2, **dadurch gekennzeichnet, dass** die schräge Achse (16) einen rechten Winkel mit der zu beleuchtenden Ebene (9) einschließt.

4. Verfahren nach einem der Ansprüche 1 bis 3, **dadurch gekennzeichnet, dass** es während der Verlagerung entlang der ersten Richtung (10) eine dynamische Modifikation des Projektionsbildes umfasst, die synchronisiert mit der Verlagerung des Projektionsbildes entlang der ersten Richtung abläuft, wobei diese Modifikation des Bildes durch eine dynamische Modifikation der Maske erhalten wird, die synchronisiert mit der Verlagerung der Maske durch Bewegung mit der Komponente entlang der schrägen Achse abläuft.

5. Verfahren nach einem der Ansprüche 1 bis 4, **dadurch gekennzeichnet, dass** der Spiegel (6) eine reflektierende Oberfläche (19) hat, die dazu angeordnet ist, das Projektionsbild zu reflektieren und die um 45°, plus oder minus 10°, zu der zu beleuchtenden Ebene geneigt ist.

6. Verfahren nach einem der Ansprüche 1 bis 5, **dadurch gekennzeichnet dass** sich zwischen der Maske (3) und dem Spiegel (6) das Projektionsbild parallel zur zu beleuchtenden Ebene (9) ausbreitet.

7. Verfahren nach einem der Ansprüche 1 bis 6, **dadurch gekennzeichnet, dass** die Maske (3) nicht parallel und vorzugsweise senkrecht zu der zu beleuchtenden Ebene (9) verläuft.

8. Verfahren nach einem der Ansprüche 1 bis 7, **dadurch gekennzeichnet, dass** das Projektionsbild (5) in der zu beleuchtenden Ebene (9) entlang der ersten Verlagerungsrichtung (10) nacheinander entlang von mehreren parallel verlaufenden Linien (22, 23, 24) verlagert wird und das Projektionsbild entlang der zweiten Verlagerungsrichtung (11) verlagert wird, um das Projektionsbild am Ende einer jeden absolvierten Linie zu einer nachfolgenden Linie, die parallel zu der absolvierten Linie verläuft, zu versetzen, so dass eine Position des Projektionsbildes auf der zu beleuchtenden Ebene entlang der absolvierten Linie an eine Position des Projektionsbildes auf der zu beleuchtenden Ebene entlang der nachfolgenden Linie angrenzt oder teilweise von dieser überlagert wird.

9. Verfahren nach einem der Ansprüche 1 bis 8, **dadurch gekennzeichnet, dass** dessen Schritte über mehrere übereinander gelagerte Schichten aus lichtempfindlichem Material wiederholt werden.

10. Vorrichtung (1; 100) zum Herstellen eines Volumenobjekts durch Lithographie, umfassend:
- einen Behälter (2), der dazu angeordnet ist, in einem Arbeitsvolumen eine Materialschicht aufzunehmen,
- eine Maske (3) und eine Strahlungsquelle (4), die dazu angeordnet sind, gemeinsam ein Projektionsbild (5) am Ausgang der Maske zu erzeugen,
- Einrichtungen (6, 7, 8) zum Projizieren des Projektionsbildes auf eine zu beleuchtende Ebene (9) in dem Arbeitsvolumen, wobei diese Projektionseinrichtungen Verlagerungseinrichtungen (6, 7) zum Verlagern des Projektionsbildes in der zu beleuchtenden Ebene entlang einer ersten Verlagerungsrichtung (10) und Verlagerungseinrichtungen (8) zum Verlagern des Projektionsbildes in der zu beleuchtenden Ebene entlang einer zweiten Verlagerungsrichtung (11) enthalten, die sich von der ersten Richtung unterscheidet und die erste Richtung nicht überlagert,
bei welcher Vorrichtung
die Verlagerungseinrichtungen (6, 7) zum Verlagern des Projektionsbildes entlang der ersten Verlagerungsrichtung (10) enthalten:
- Einrichtungen (7) zum Verlagern der Maske durch Bewegung mit einer Komponente (15) entlang einer schrägen Achse (16), die einen Winkel (17) mit der zu beleuchtenden Ebene (9) einschließt,
- einen Spiegel (6), der dazu angeordnet ist, das von der Maske (3) stammende Projektionsbild (5) zur zu beleuchtenden Ebene (9) zu reflektieren und die Bewegung der Maske (3) mit der Komponente (15) entlang der schrägen Achse (16), die den Winkel (17) mit der zu beleuchtenden Ebene (9) einschließt, in eine Verlagerung des Projektionsbildes (5) auf der zu beleuchtenden Ebene (9) entlang der ersten Verlagerungsrichtung (10), die in der zu beleuchtenden Ebene (9) enthalten ist, umzuwandeln.

11. Vorrichtung nach Anspruch 10, **dadurch gekennzeichnet, dass** die Verlagerungseinrichtungen (7) zum Verlagern der Maske (3) durch Bewegung mit der Komponente (15) entlang der schrägen Achse (16) dazu angeordnet sind, die Maske (3) entlang der schrägen Achse (16) zu verlagern.

12. Vorrichtung nach Anspruch 10 oder 11, **dadurch gekennzeichnet, dass** die schräge Achse (16) einen rechten Winkel mit der zu beleuchtenden Ebene (9) einschließt.

13. Vorrichtung nach einem der Ansprüche 10 bis 12, **dadurch gekennzeichnet, dass** sie ferner Einrichtungen zur dynamischen Modifikation des Projektionsbildes enthält, die synchronisiert mit der Verlagerung des Projektionsbildes (5) entlang der ersten Richtung (10) abläuft, sowie Einrichtungen zur dynamischen Modifikation der Maske (3), die synchronisiert mit der Bewegung der Maske mit der Komponente (15) entlang der schrägen Achse (16) abläuft.

14. Vorrichtung nach einem der Ansprüche 10 bis 13, **dadurch gekennzeichnet, dass** der Spiegel (6) eine reflektierende Oberfläche (19) hat, die dazu angeordnet ist, das Projektionsbild zu reflektieren und die um 45°, plus oder minus 10°, zu der zu beleuchtenden Ebene (9) geneigt ist.

15. Vorrichtung nach einem der Ansprüche 10 bis 14, **dadurch gekennzeichnet dass** die Einrichtungen (6, 7, 8) zum Projizieren des Projektionsbildes dazu angeordnet sind, dieses Bild so zu projizieren, dass zwischen der Maske (3) und dem Spiegel (6) das Projektionsbild (5) sich parallel zur zu beleuchtenden Ebene (9) ausbreitet.

16. Vorrichtung nach einem der Ansprüche 10 bis 15, **dadurch gekennzeichnet, dass** die Maske (3) nicht parallel und vorzugsweise senkrecht zu der zu beleuchtenden Ebene (9) verläuft.

17. Vorrichtung nach einem der Ansprüche 10 bis 16, **dadurch gekennzeichnet, dass** die Einrichtungen (6, 7) zum Verlagern des Projektionsbildes (5) entlang der ersten Verlagerungsrichtung (10) dazu angeordnet sind, das Projektionsbild (5) in der zu beleuchtenden Ebene (9) nacheinander entlang von mehreren parallel verlaufenden Linien (22, 23, 24) zu verlagern, wobei die Einrichtungen (8) zum Verlagern des Projektionsbildes entlang der zweiten Verlagerungsrichtung dazu angeordnet sind, das Projektionsbild am Ende einer jeden absolvierten Linie zu einer nachfolgenden Linie, die parallel zu der absolvierten Linie verläuft, zu versetzen, so dass eine Position des Projektionsbildes auf der zu beleuchtenden Ebene entlang der absolvierten Linie an eine Position des Projektionsbildes auf der zu beleuchtenden Ebene entlang der nachfolgenden Linie angrenzt oder teilweise von dieser überlagert wird.

18. Vorrichtung nach einem der Ansprüche 10 bis 17, **dadurch gekennzeichnet, dass** die Einrichtungen (6, 7, 8) zum Projizieren des Projektionsbildes auf der zu beleuchtenden Ebene dazu angeordnet sind, das Projektionsbild auf verschieden mögliche, zu beleuchtenden Ebenen (9, 9', 9") projizieren zu können, die parallel verlaufen und in dem Arbeitsvolumen enthalten sind.

## Claims

1. Method for producing a 3D object by means of lithography, comprising:
a) providing a layer of photosensitive material in a working volume, which material is arranged so as to harden under the influence of radiation,
b) creating, using a mask (3) and a radiation source (4), a projection image (5) at the outlet of the mask,
c) projecting the projection image onto a plane (9) of the material layer that is to be illuminated,
d) moving the projection image (5), in the plane (9) to be illuminated, in a first movement direction (10), and moving the projection image, in the plane (9) to be illuminated, in a second movement direction (11) that is different from the first direction and is not superimposed on the first direction, said two movement directions being contained in the plane (9) to be illuminated, method wherein, in order to move the projection image in the first movement direction (10):
- the mask (3) is moved in accordance with a movement having a component (15) along an oblique axis (16) that forms an angle (17) with the plane (9) to be illuminated, and
- said movement of the mask (3) having the component (15) along the oblique axis (16) that forms an angle (17) with the plane (9) to be illuminated is transformed into the movement of the projection image (5), in the plane (9) to be illuminated, in the first movement direction (10) contained in the plane (9) to be illuminated, by means of a mirror (6) that reflects the projection image (5) from the mask (3) towards the plane (9) to be illuminated.

2. Method according to claim 1, **characterised in that**, in order to move the mask (3) in accordance with the movement having the component (15) along the oblique axis (16), the mask (3) is moved along the oblique axis (16).

3. Method according to either claim 1 or claim 2, **characterised in that** the oblique axis (16) forms a right angle with the plane (9) to be illuminated.

4. Method according to any of claims 1 to 3, **characterised in that** said method comprises, during the movement in the first direction (10), a dynamic modification of the projection image, which modification is synchronised with the movement of the projection image in the first direction, said modification of the image being obtained by means of a dynamic modification of the mask, which modification is synchronised with the movement of the mask in accordance with the movement thereof having the component along the oblique axis.

5. Method according to any of claims 1 to 4, **characterised in that** the mirror (6) has a reflective surface (19) that is arranged so as to reflect the projection image and that is inclined by 45°, ± 10°, with respect to the plane to be illuminated.

6. Method according to any of claims 1 to 5, **characterised in that** the projection image propagates in parallel with the plane (9) to be illuminated, between the mask (3) and the mirror (6).

7. Method according to any of claims 1 to 6, **characterised in that** the mask (3) is not in parallel with, and is preferably perpendicular to, the plane (9) to be illuminated.

8. Method according to any of claims 1 to 7, **characterised in that** the projection image (5) is moved, in the plane (9) to be illuminated, in the first movement direction (10), successively along a plurality of parallel lines (22, 23, 24), and the projection image is moved in the second movement direction (11) in order to shift the projection image, at the end of each finished line, to a following line that is in parallel with the finished line, such that a position of the projection image on the plane to be illuminated is bordered or superimposed in part, along the finished line, by a position of the projection image, on the plane to be illuminated, along the following line.

9. Method according to any of claims 1 to 8, **characterised in that** the steps thereof are repeated on a plurality of photosensitive layers placed on top of one another.

10. Device (1; 100) for producing a 3D object by means of lithography, comprising:
- a receptacle (2) for receiving, in a working volume, a layer of material,
- a mask (3) and a radiation source (4) arranged so as to create, together, a projection image (5) at the outlet of the mask,
- means (6, 7, 8) for projecting the projection image onto a plane (9) to be illuminated in the working volume, said projection means comprising means (6, 7) for moving the projection image, in the plane to be illuminated, in a first movement direction (10), and means (8) for moving the projection image, in the plane to be illuminated, in a second movement direction (11) that is different from the first direction and is not superimposed on the first direction, device wherein the means (6, 7) for moving the projection image in the first movement direction (10) comprise:
- means (7) for moving the mask in accordance with a movement having a component (15) along an oblique axis (16) that forms an angle (17) with the plane (9) to be illuminated,
- a mirror (6) that is arranged so as to reflect the projection image (5) from the mask (3) towards the plane (9) to be illuminated, and to transform the movement of the mask (3) having the component (15) along the oblique axis (16) that forms the angle (17) with the plane (9) to be illuminated into a movement of the projection image (5), on the plane (9) to be illuminated, in the first movement direction (10) contained in the plane (9) to be illuminated.

11. Device according to claim 10, **characterised in that** the means (7) for moving the mask (3) in accordance with the movement having the component (15) along the oblique axis (16) are arranged so as to move the mask (3) along the oblique axis (16).

12. Device according to either claim 10 or claim 11, **characterised in that** the oblique axis (16) forms a right angle with the plane (9) to be illuminated.

13. Device according to any of claims 10 to 12, **characterised in that** said device further comprises means for dynamically modifying the projection image in a manner synchronised with the movement of the projection image (5) in the first direction (10), comprising means for dynamically modifying the mask (3) in a manner synchronised with the movement of the mask having the component (15) along the oblique axis (16).

14. Device according to any of claims 10 to 13, **characterised in that** the mirror (6) has a reflective surface (19) that is arranged so as to reflect the projection image and is inclined by 45°, ± 10°, with respect to the plane (9) to be illuminated.

15. Device according to any of claims 10 to 14, **characterised in that** the means (6, 7, 8) for projecting the projection image are arranged so as to project said image such that the projection image (5) propagates in parallel with the plane (9) to be illuminated, between the mask (3) and the mirror (6).

16. Device according to any of claims 10 to 15, **characterised in that** the mask (3) is not in parallel with, and is preferably perpendicular to, the plane (9) to be illuminated.

17. Device according to any of claims 10 to 16, **characterised in that** the means (6, 7) for moving the projection image (5) in the first movement direction (10) are arranged so as to move the projection image (5), in the plane (9) to be illuminated, in the first movement direction (10), successively along a plurality of parallel lines (22, 23, 24), the means (8) for moving the projection image in the second movement direction being arranged so as to shift the projection image, at the end of each finished line, to a following line that is in parallel with the finished line, such that a position of the projection image on the plane to be illuminated is bordered or superimposed in part, along the finished line, by a position of the projection image, on the plane to be illuminated, along the following line.

18. Device according to any of claims 10 to 17, **characterised in that** the means (6, 7, 8) for projecting the projection image onto the plane to be illuminated are arranged so as to be able to project the projection image onto different possible planes (9, 9', 9") to be illuminated that are in parallel and are contained in the working volume.
